# EUROPEAN PATENT SPECIFICATION

(11) **EP 2 381 497 B1**
(45) Date of publication and mention of the grant of the patent: **14.09.2016**
(21) Application number: 09838672.5
(22) Date of filing: 09.12.2009
(51) Int. Cl.: H01L 35/32, H01L 35/34

(54) **THIN FILM TEMPERATURE-DIFFERENCE CELL AND FABRICATING METHOD THEREOF**
TEMPERATURDIFFERENZ-DÜNNSCHICHTZELLE UND HERSTELLUNGSVERFAHREN DAFÜR
CELLULE À COUCHE MINCE À DIFFÉRENCE DE TEMPÉRATURE ET SON PROCÉDÉ DE FABRICATION

(30) Priority: 20.01.2009 CN 200910105172
(43) Date of publication of application: 26.10.2011
(73) Proprietor: Shenzhen Caihuang Enterprise & Development Co., Ltd, Shenzhen, 518109 (CN)
(72) Inventor: FAN, Ping, Shenzhen Guangdong 518060 (CN); ZHANG, Dongping, Shenzhen Guangdong 518060 (CN); ZHENG, Zhuanghao, Shenzhen Guangdong 518060 (CN); LIANG, Guangxing, Shenzhen Guangdong 518060 (CN)
(74) Representative: Bosch, Matthias
(86) International application number: PCT/CN2009/075419
(87) International publication number: WO 2010/083705

(56) References cited:
- WO-A1-00/30185
- CN-A- 101 079 465
- CN-A- 101 521 259
- JP-A- 7 035 618
- JP-A- 8 032 126
- JP-A- S5 646 577
- JP-A- H02 214 175
- JP-A- H05 327 033
- JP-A- H08 125 240
- JP-A- 2008 205 181
- US-A- 6 043 423
- US-A1- 2007 125 413

## Description

### FIELD OF THE INVENTION

This invention relates to thermo-electric technology, and more particularly to a thin-film temperature-difference cell and fabrication method thereof.

### BACKGROUND OF THE INVENTION

The temperature-difference cell is a kind of generator made on the basis of Seebeck Effect, the heat energy is transformed into electric energy. The working principle of temperature-difference cell is that connecting one end of two different metals or two different types of thermo-electric conversion materials P-type and N-type semiconductors, placing this end in high temperature condition, and placing the other end in low temperature condition. Compared with the other end, the end in high temperature condition has better thermal activation and higher density of electrons and holes, the electrons and holes spread to the end in low temperature condition, thus an electric potential difference is formed in the end in low temperature condition. Combing a number of this kind of thermo-electric conversion materials P-type and N-type semiconductors to form a module supplying adequate voltage, this module becomes a temperature-difference cell.

The temperature-difference cell is a kind of clean, noiseless energy without discharging any hazardous substance, having high reliability and long useful time, and supplying long, safe, continuous and stable electricity output. Presently the temperature-difference cell is made by cutting and welding the thermo-electric materials. There are two types of fabrication methods. In the first method, depositing a photosensitive resist on the same chip, then forming a P-type and N-type area through double photo etching respectively, and finally depositing P-type and N-type thermo-electric materials in the P-type and N-type area respectively. This method is difficult for application, especially for the procedure of combining thermo-electric units in which the chip is required to be stripped from the deposited thermo-electric units. In the second method, P-type and N-type thermo-electric unit chip is separately manufactured, in the fabrication of micro thin-film temperature-difference cell, the conducting layer connecting P-type and N-type thermo-electric units can be manufactured on condition that the chip is not stripped from the deposited thermo-electric units. This method has complicated procedures, and the thin-film of the temperature-difference cell is merely limited to single thin-film, so the performance is limited.

JP2008205181 discloses a thermoelectric module made with alternating thin films of N and P type thermoelectric material. JP05327033 discloses a thermoelectric power conversion device comprising semiconductor layers formed on different sides of an insulating substrate.

### SUMMARY OF THE INVENTION

To solve the above-mentioned problems, this invention provides a thin-film temperature-difference cell and fabrication method thereof, improving the performance and simplifying the fabrication processes.

The technical solutions of the present invention are as follows:
A thin-film temperature-difference cell comprises:
   a substrate, a plurality of P-type thermo-electric thin-film layer, a plurality of insulating thin-film layer; a plurality of N-type thermo-electric thin-film layer and two electrodes; wherein the P-type thermo-electric thin-film layer and the N-type thermo-electric thin-film layer are deposited on two opposed sides of said substrate, and alternating with each other;a three-layer film formed by a group of said P-type thermo-electric thin-film layer, said insulating thin-film layer and said N-type thermo-electric thin-film layer, wherein said P-type thermo-electric thin-film layer and said N-type thermo-electric thin-film layer of said three-layer film are connected together at one end of said insulating thin-film layer to form a PN junction;an insulating layer deposited between two adjacent said PN junctions for separating, wherein said two adjacent PN junctions separated by said insulating layer are connected together at one end of the insulating layer, in order to form PN junctions in series;wherein the two electrodes are respectively extracted from the outermost thin-film layer on two sides of said substrate.

A method for fabricating a thin-film thermo-electric generator, comprising depositing multilayer films on the two sides of the substrate, and further comprises steps as follows:selecting a substrate and sheltering one side of said substrate;depositing a P-type thermo-electric thin-film layer on one side of the substrate;sheltering said substrate and sheltering one end and all sides of the deposited thin-film layer, and depositing an insulating thin-film layer on said P-type thermo-electric thin-film layer;sheltering said substrate and the sides of the deposited thin-film layer, depositing a N-type thermo-electric thin-film layer on the deposited insulating thin-film layer to form a three-layer film, wherein the P-type thermo-electric thin-film layer and N-type thermo-electric thin-film layer of said three-layer film are connected together at said sheltered end of the substrate to form a PN junction;repeating the steps described above to form multiple PN junctions;depositing an insulating thin-film layer between every two adjacent PN junctions while sheltering said substrate and sheltering the other end and all sides of the deposited thin-film layers during the depositing process, wherein said two adjacent three-layer PN junctions are connected together at the other sheltered end of said deposited thin-film layers to form PN junctions in series;extracting one electrode from the outermost thin-film layer of the last three-layer PN junction;repeating the steps described above to form multiple three-layer PN junctions in series on the other side of said substrate, extracting another electrode from the outermost thin-film layer of the last three-layer PN junction on the other side of said substrate, to form the main structure of a thin-film thermo-electric generator.

For the thin-film temperature-difference cell and fabrication method of this invention, a P-type thermo-electric thin-film layer, an insulating thin-film layer and a N-type thermo-electric thin-film layer are deposited on a substrate to form a PN junction with three films, multiple three-layer PN junctions in series are available, an insulating thin-film layer is provided between the PN junctions of each of the three-layer PN junctions in series for separating, and electrodes are extracted from the upper side of the substrate and the outermost thin-film layer of the last three-layer thin-film PN junctions, respectively. The present invention applies the deposition of P-type thermo-electric thin-film layer, an insulating thin-film layer and a N-type thermo-electric thin-film layer to form a three-layer PN junction, thus a thermocouple is formed, during the deposition of the insulating thin-film layer, intentionally sheltering the substrate and one end of the deposited thin-film layer enable the P-type or N-type materials to be deposited on the substrate and one end of the deposited thin-film layer directly, to form a connection end of PN junction or a serial connection end between two PN junctions, the special connection with the P-type and N-type materials is not necessary, simplifying the fabrication processes of the thin-film temperature-difference cell, owning to the characteristics of the thin-film thermo-electric materials and serial connection structure of multiple three-layer PN junctions, the performance of the thin-film temperature-difference cell is greatly improved.

### BRIEF DESCRIPTION OF THE DRAWINGS

FIG. 1a- FIG. 1i are the schematic diagrams of the fabrication process of a first embodiment
FIG. 2a- FIG. 2h are the schematic diagrams of the fabrication process of a second embodiment.
FIG. 3a- FIG. 3g are the schematic diagrams of the fabrication process of the embodiment of the invention.
FIG. 4a- FIG. 4h are the schematic diagrams of the fabrication process of the forth embodiment of the invention.
FIG. 5a- FIG. 5g are the schematic diagrams of the fabrication process of the fifth embodiment of the invention.

### DETAILED DESCRIPTION OF ILLUSTRATIVE EMBODIMENTS

The present invention provides a thin-film temperature-difference cell and fabrication method thereof. To make the technical solutions of the present invention more comprehensible, the present invention is described in detail with reference to the accompanying drawings and embodiments as follows.

### The First Embodiment

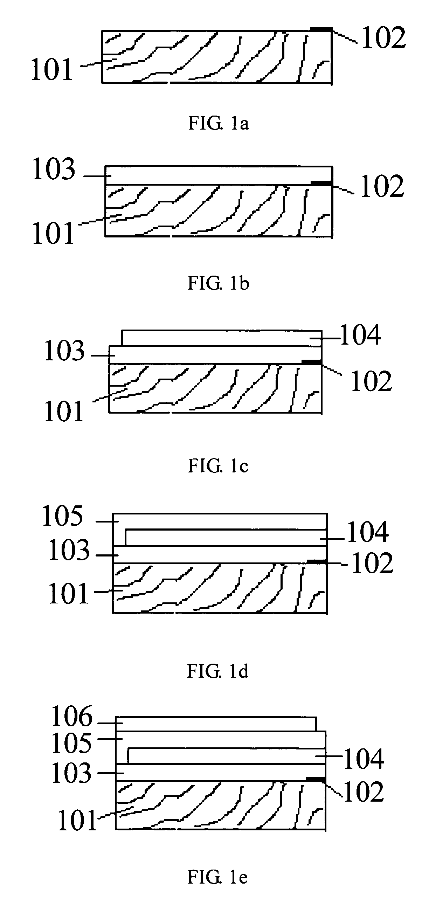

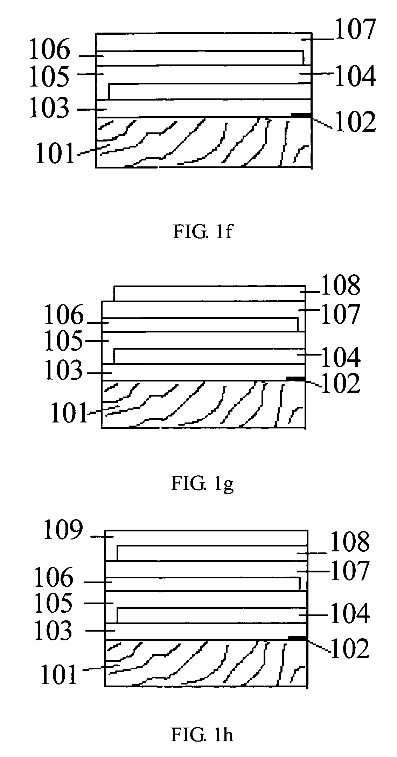

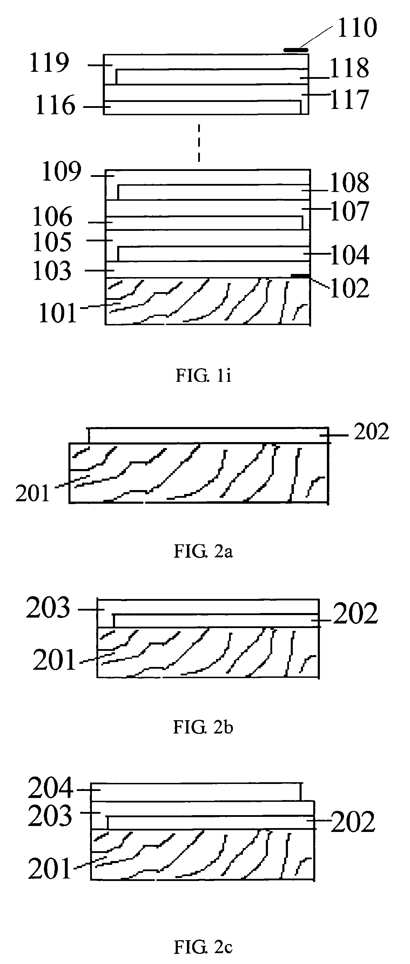

FIG. 1a- FIG. 1i are the schematic diagrams of the fabrication process of a first
embodiment FIG. 1i is the schematic diagrams of the end of the thin-film temperature-difference cell. In the first embodiment, the thin-film temperature-difference cell comprises an insulating substrate 101, an extractive electrode 102, a P-type thermo-electric thin-film layer 103, an insulating thin-film layer 104, a N-type thermo-electric thin-film layer 105, an insulating thin-film layer 106, a P-type thermo-electric thin-film layer 107, an insulating thin-film layer 108, a N-type thermo-electric thin-film layer 109, and an extractive electrode 110.

FIG. 1a shows a preset electrode 102 on a surface of the insulating substrate 101.

FIG. 1b shows a P-type thermo-electric thin-film layer 103 deposited on the side of the substrate on which the electrode is preset.

FIG. 1c shows an insulating thin-film layer 104 deposited on the P-type thermo-electric thin-film layer 103.

FIG. 1d shows a N-type thermo-electric thin-film layer 105 deposited on the insulating thin-film layer 104.

FIG. 1e shows an insulating thin-film layer 106 deposited on the N-type thermo-electric thin-film layer 105.

FIG. If shows a P-type thermo-electric thin-film layer 107 deposited on the insulating thin-film layer 106.

FIG. 1g shows an insulating thin-film layer 108 deposited on the P-type thermo-electric thin-film layer 107.

FIG. 1h shows a N-type thermo-electric thin-film layer 109 deposited on the insulating thin-film layer 108.

FIG. 1i shows an insulating thin-film layer 116, a P-type thermo-electric thin-film layer 117, an insulating thin-film layer 118 and a N-type thermo-electric thin-film layer 119 formed by repeating depositing steps 106-109.

The P-type thermo-electric thin-film layer and the N-type thermo-electric thin-film layer are connected together at one end of the insulating thin-film layer to form a three-layer PN junction. An insulating layer is deposited between two adjacent PN junctions for separating, and the two adjacent PN junctions are connected together at one end of the insulating layer, in order to form PN junctions in series. Another electrode 110 is extracted from the N-type thermo-electric thin-film layer 119 of the last three-layer PN junction. Thus, the main structure of thin-film temperature-difference cell as shown in Fig. 1i is formed. Then the thin-film temperature-difference cell is fabricated by scribing, racking, packaging and conventional subsequent procedures.

The general materials of the thin-film temperature-difference cell are metal and semiconductor. The P-type and N-type thermo-electric materials may be two different metals or two different semiconductors, that a thermocouple may be formed by depositing two different metal films or two different semiconductors. During the fabrication process, the depositing of N-type thermo-electric thin-film layer can be carried out before or after the depositing of P-type thermo-electric thin-film layer.

Several methods can be applied to make the P-type and N-type thermo-electric thin-film layers, such as vacuum evaporation, Molecule Beam Epitaxy (MBE), magnetron sputtering, ion beam sputtering deposition, Laser Deposition, electrochemical atomic layer epitaxy (ECALE), metal-organic chemical vapor deposition (MOCVD), and successive ionic layer adsorption and reaction (SILAR).

The first embodiment provides a fabrication process of the thin-film temperature-difference cell utilizing the ion beam sputtering deposition:
The device is an ultrahigh vacuum ion beam sputtering deposition system. Selecting metals S_{b} and B_{¡} with Seebeck coefficient of P-type and N-type respectively, and insulating material *Al*₂*O*₃ as target materials, the purity of the target material is 99.99%, and setting these targets in the target sites capable of rotating as to select target materials, respectively. After ultrasonic wash using organic solvents, the substrate of common soda-lime glass may be put it in a clamping fixture in the deposition room. The fixture may further have apparatuses for intentionally sheltering the two ends and the sides of the substrate. At room temperature, the deposition is carried out by adjusting the targets in turn and using ion beam sputtering deposition, the procedures is as below:
   Step 1: as shown in Fig. 1a, presetting electrode 102 on one side of the glass substrate 101 and sheltering all sides of the substrate 101;
   Step 2: as shown in Fig. 1b, depositing S_{b} thin-film layer 103 with a thickness of 300nm on the side of the substrate 101 on which the electrode is preset.
   Step 3: as shown in Fig. 1c, sheltering the substrate 101, one end and all sides of the S_{b} thin-film layer 103, and depositing *Al*₂*O*₃ thin-film layer 104 with a thickness of 500nm on the S_{b} thin-film layer 103.
   Step 4: as shown in Fig. 1d, sheltering the substrate 101 and all sides of the deposited thin-film layers, and depositing a Bᵢ thin-film layer 105 with a thickness of 300nm on the deposited *Al*₂*O*₃ thin-film layer 104, the S_{b} thin-film layer 103 and the Bi thin-film layer 105 are deposited and connected together on one end of the *Al*₂*O*₃ thin-film layer 104 to form the first PN junction.
   Step 5: as shown in Fig. 1e, sheltering the substrate 101 and all sides of the deposited thin-film layers, and depositing thick *Al*₂*O*₃ thin-film layer 106 with a thickness of 500nm on the Bi thin-film layer 105.
   Step 6: as shown in Fig. If, sheltering the substrate 101 and all sides of the deposited thin-film layers, and depositing S_{b} thin-film layer 107 with a thickness of 300nm on the *Al*₂*O*₃ thin-film layer 106, the S_{b} thin-film layer 107 and the B_{¡} thin-film layer 105 are deposited and connected together on one end of the *Al*₂*O*₃ thin-film layer 106 to form a connecting end between the first and the second PN junction.
   Step 7 as shown in Fig. 1g, sheltering the substrate 101, one end and all sides of the deposited thin-film layers, and depositing *Al*₂*O*₃ thin-film layer 108 with a thickness of 500nm on the Sb thin-film layer 107.
   Step 8: as shown in Fig. 1h, sheltering the substrate 101 and all sides of the deposited thin-film layers, and depositing Bᵢ thin-film layer 109 with a thickness of 300nm on the *Al*₂*O*₃ thin-film layer 108, the S_{b} thin-film layer 107 and the B_{¡} thin-film layer 109 are deposited and connected together on one end of the *Al*₂*O*₃ thin-film layer 108 to form a second PN junction. The first and the second PN junction are connected in series through the *Al*₂*O*₃ thin-film layer 106.
   Step 9: as shown in Fig. 1i, repeating the steps from Step 5 to Step 8 for depositing 106-109 to form a *Al*₂*O*₃ thin-film layer 116, a S_{b} thin-film layer 117, a *Al*₂*O*₃ thin-film layer 118, and a Bᵢ thin-film layer 119 respectively, accordingly a connection in series between a PN junction and a deposited PN junction is made, the connection of multiple three-layer PN junctions in series is available, an insulating layer is set between every three-layer PN junction for separating. During the deposition, the background vacuum degree is 4.5×10⁻⁴ *Pa,* the working vacuum degree is 4.1×10⁻*² Pa,* and the working gas is Ar gas with a purity of 99.99% and with a rate of flow of 4sccm. The technical parameters of the ion beam sputtering deposition are as below: plate voltage of 1KV, anode voltage of 75V, acceleration voltage of 220V, cathode voltage of 7V, cathode current of 11A, and beam of 14mA. After obtaining one or multiple three-layer PN junctions in series by depositing on the substrate 101, another electrode 110 is extracted from the Bᵢ thin-film layer 119 of the last PN junction, thus the main structure of the thin-film temperature-difference cell as shown in Fig. 1i is formed.

During the fabrication process described above, the depositing of N-type thermo-electric thin-film layer can be carried out before or after the depositing of P-type thermo-electric thin-film layer.

In the first embodiment the fabrication processes of thin-film temperature-difference cell with the magnetron sputtering are as below:
The device is a three-target magnetron sputtering system. Select metals S_{b}, Bᵢ and Al as target materials with the purity of 99.99%, and set these targets in the target site respectively. After ultrasonic wash, the substrate of common soda-lime glass may be put in fixture in the deposition room. The fixture may further have apparatuses for intentional sheltering the two ends and the sides. At room temperature, during the deposition, the background vacuum is 4.5×10⁻³ *Pa,* the working vacuum is 4.1×10⁻² *Pa.* During the deposition of S_{b} and B_{¡} thin-film layer with DC magnetron sputtering, the working gas is Ar gas with a purity of 99.99% and with a rate of flow of 50sccm. During the deposition of the *Al*₂*O*₃ thin-film layer with direct current magnetron reactive sputtering, the working gas is Ar gas with a purity of 99.99% and with a rate of flow of 50sccm and the reactive gas is O₂ gas with a purity of 99.99% and with a rate of flow of 50sccm. The processes of deposition are described as follows:
   Step 1: as shown in Fig. 1a, presetting electrode 102 on one side of the glass substrate 101 and sheltering all sides of the substrate 101;
   Step 2: as shown in Fig. 1b, depositing S_{b} thin-film layer 103 with a thickness of 300nm on the side of the substrate 101 on which the electrode is preset.
   Step 3: as shown in Fig. 1c, sheltering the substrate 101, one end and all sides of the S_{b} thin-film layer 103, and depositing *Al*₂*O*₃ thin-film layer 104 with a thickness of 500nm on the S_{b} thin-film layer 103.
   Step 4: as shown in Fig. 1d, sheltering the substrate 101 and all sides of the deposited thin-film layers, and depositing Bᵢ thin-film layer 105 with a thickness of 300nm on the deposited *Al*₂*O*₃ thin-film layer 104, the S_{b} thin-film layer 103 and the Bᵢ thin-film layer 105 are deposited and connected together on one end of the *Al*₂*O*₃ thin-film layer 104 to form the first PN junction.
   Step 5: as shown in Fig. 1e, sheltering the substrate 101 and sheltering the other end and all sides of the deposited thin-film layers, and depositing *Al*₂*O*₃ thin-film layer 106 with a thickness of 500nm on the Bᵢ thin-film layer 105.
   Step 6: as shown in Fig. If, sheltering the substrate 101 and all sides of the deposited thin-film layers, and depositing S_{b} thin-film layer 107 with a thickness of 300nm on the *Al*₂*O*₃ thin-film layer 106, the S_{b} thin-film layer 107 and the Bᵢ thin-film layer 105 are deposited and connected together on one end of the *Al*₂*O*₃ thin-film layer 106 to form a connecting end between the first and the second PN junction.
   Step 7 as shown in Fig. 1g, sheltering the substrate 101, and one end and all sides of the deposited thin-film layers, and depositing *Al*₂*O*₃ thin-film layer 108 with a thickness of 500nm on the S_{b} thin-film layer 107.
   Step 8: as shown in Fig. 1h, sheltering the substrate 101 and all sides of the deposited thin-film layers, and depositing Bᵢ thin-film layer 109 with a thickness of 300nm on the *Al*₂*O*₃ thin-film layer 108, the S_{b} thin-film layer 107 and the Bᵢ thin-film layer 109 are deposited and connected together on one end of the *Al*₂*O*₃ thin-film layer 108 to form a second PN junction. The first and the second PN junction are connected in series through the *Al*₂*O*₃ thin-film layer 106.
   Step 9: as shown in Fig. 1i, repeating the steps from Step 5 to Step 8 for depositing 106-109 to form a *Al*₂*O*₃ thin-film layer 116, a S_{b} thin-film layer 117, a *Al*₂*O*₃ thin-film layer 118, and a Bᵢ thin-film layer 119 respectively, accordingly a connection in series between a PN junction and a deposited PN junction is made, the connection of multiple three-layer PN junctions in series is available, an insulating layer is set between every three-layer PN junction for separating.

After obtaining one or multiple three-layer PN junctions in series by depositing on the substrate 101, another electrode 110 is extracted from the Bᵢ thin-film layer 119 of the last PN junction, thus the main structure of the thin-film temperature-difference cell as shown in Fig. 1i is formed.

During the above-said fabrication process, the depositing of N-type thermo-electric thin-film layer can be carried out before or after the depositing of P-type thermo-electric thin-film layer.

### Second Embodiment

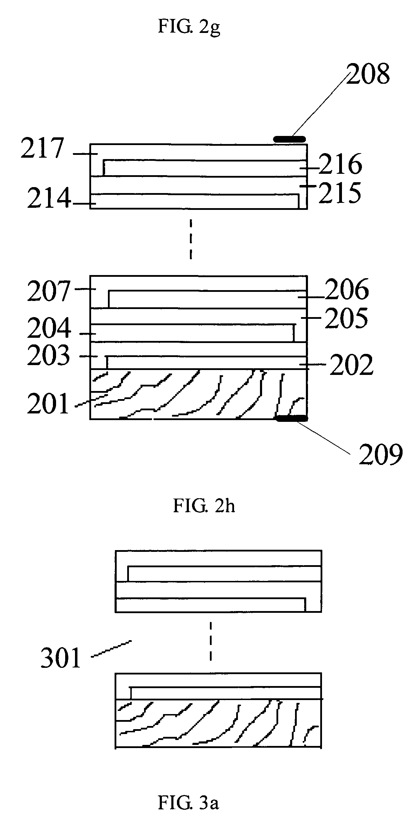

The thin-film temperature-difference cell can be made by using the insulating substrate as well as the substrate of P-type thermo-electric material (or metal) or N-type thermo-electric material (or metal). If the substrate of P-type thermo-electric material is applied, the cross-section diagram of the thin-film temperature-difference cell is shown in Fig. 2h. In this embodiment, the thin-film temperature-difference cell comprises a P-type thermo-electric material substrate 201, an insulating thin-film layer 202, a N-type thermo-electric thin-film layer 203, an insulating thin-film layer 204, a P-type thermo-electric thin-film layer 205, an insulating thin-film layer 206, a N-type thermo-electric thin-film layer 207, an extractive electrode 208 and an extractive electrode 209.

FIG. 2a shows the insulating thin-film layer 202 deposited on the P-type thermo-electric material substrate 201.

FIG. 2b shows the N-type thermo-electric thin-film layer 203 deposited on the insulating thin-film layer 202.

FIG. 2c shows the insulating thin-film layer 204 deposited on the N-type thermo-electric thin-film layer 203.

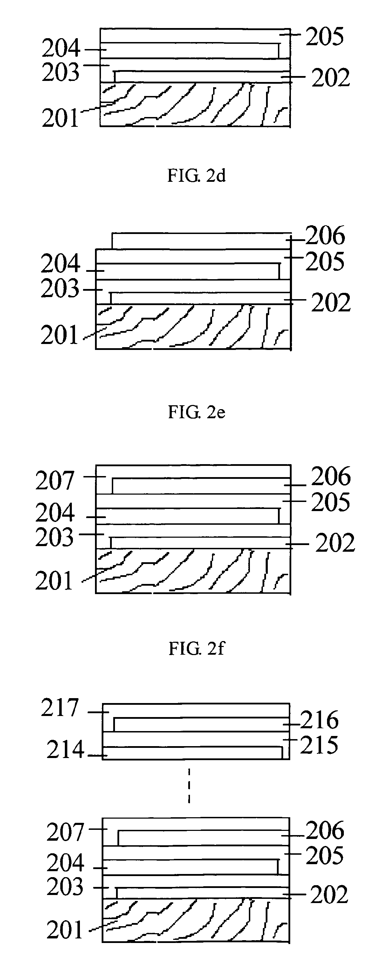

FIG. 2d shows the P-type thermo-electric thin-film layer 205 deposited on the insulating thin-film layer 204.

FIG. 2e shows the insulating thin-film layer 206 deposited on the P-type thermo-electric thin-film layer 205.

FIG. 2f shows the N-type thermo-electric thin-film layer 207 deposited on the insulating thin-film layer 206.

FIG. 2g shows an insulating thin-film layer 214, a P-type thermo-electric thin-film layer 215, an insulating thin-film layer 216 and a N-type thermo-electric thin-film layer 217 formed by repeating steps 204-207 for depositing.

Thus a connection of a PN junction with deposited PN junctions in series is formed. Multiple connections of three-layer PN junctions in series may be applied, and an insulating thin-film layer is provided between every the PN junction for separating. The P-type thermo-electric thin-film layer and the N-type thermo-electric thin-film layer of the three films are connected together at one end of the insulating thin-film layer to form a PN junction. An insulating thin-film layer is provided between two adjacent PN junctions, and the two adjacent three-layer PN junctions separated by the insulating thin-film layer are connected together at one end of the insulating thin-film layer, in order to form PN junctions in series. An electrode 208 is extracted from the N-type thermo-electric thin-film layer 217 of the last three-layer PN junction; an electrode 209 is extracted from the side which is not deposited of the P-type thermo-electric material substrate 201. Thus, the main structure of the thin-film temperature-difference cell using the P-type thermo-electric material as substrate as shown in Fig. 2h is formed.

For the improvement of second embodiment, if the N-type thermo-electric material is applied as the substrate, the N-type thermo-electric thin-film layer and the P-type thermo-electric thin-film layer shall be exchanged in the fabrication process.

### The Third Embodiment

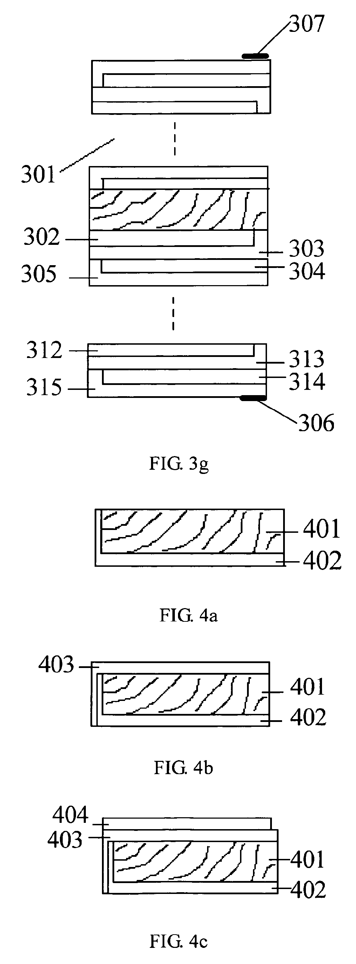

The embodiment of the present invention is based on the structure of thin-film temperature-difference cell applying P-type thermo-electric material as the substrate as shown in FIG. 2g, depositing multiple three-layer PN junctions in series on the other side of the P-type thermo-electric substrate 201, such that an insulating thin-film layer is provided between every three-layer PN junction for separating, to form a thin-film temperature-difference cell provided in the third embodiment. As shown in FIG. 3g, the thin-film temperature-difference cell in this embodiment comprises a structure basis 301 of thin-film temperature-difference cell using P-type thermo-electric material as the substrate, an insulating thin-film layer 302, a N-type thermo-electric thin-film layer 303, an insulating thin-film layer 304, a P-type thermo-electric thin-film layer 305 , an extractive electrode 306 and an extractive electrode 307.

FIG. 3a shows structure basis 301 of thin-film temperature-difference cell using P-type thermo-electric material as the substrate in the FIG. 2g.

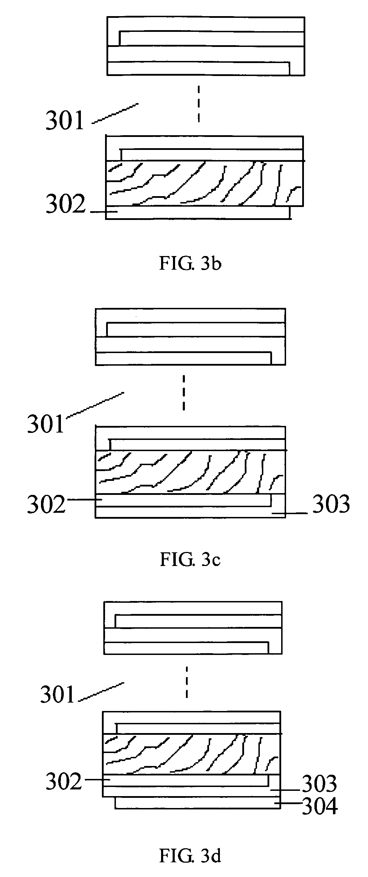

FIG. 3b shows an insulating thin-film layer 302 deposited on the other side of structure basis 301 of thin-film temperature-difference cell using P-type thermo-electric material as the substrate in the second embodiment of this invention.

FIG. 3c shows a N-type thermo-electric thin-film layer 303 deposited on the insulating thin-film layer 302.

FIG. 3d shows the insulating thin-film layer 304 deposited on the N-type thermo-electric thin-film layer 303.

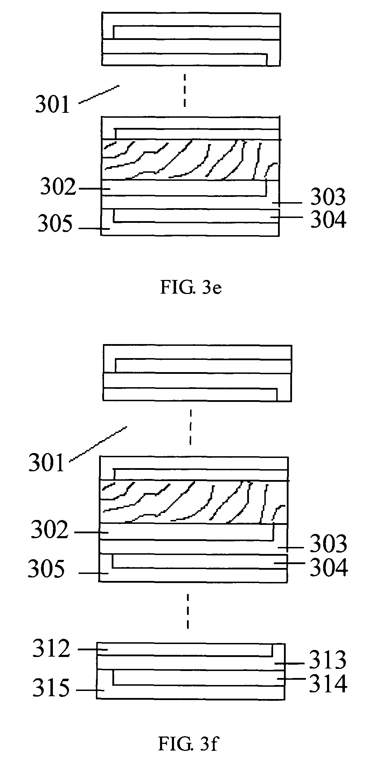

FIG. 3e shows the P-type thermo-electric thin-film layer 305 deposited on the insulating thin-film layer 304.

FIG. 3f shows an insulating thin-film layer 312, a P-type thermo-electric thin-film layer 313, an insulating thin-film layer 314 and a N-type thermo-electric thin-film layer 315 formed by repeating steps 302-305 for depositing, thus a PN junction may connect in series with the deposited PN junctions. Multiple connections of three-layer PN junctions in series are available; an insulating thin-film is applied between every PN junction for separating. The three-layer P-type thermo-electric thin-film layer and N-type thermo-electric thin-film layer are connected together at one end of the insulating thin-film layer, to form a PN junction. An insulating thin-film layer is applied between every two adjacent PN junctions for separating, and the PN junctions separated by the insulating thin-film layer are connected together at one end of the insulating thin-film layer, to form connections of PN junctions in series.

An electrode 306 and an electrode 307 is extracted from the N-type thermo-electric thin-film layer of the last three-layer PN junction on the two sides of the P-type thermo-electric thin-film substrate respectively to form the main structure of the thin-film temperature-difference cell with both sides of P-type thermo-electric thin-film substrate deposited, as shown in FIG. 3g.

For the improvement of the third embodiment, if the N-type thermo-electric material is applied as the substrate, the N-type thermo-electric thin-film layer and the P-type thermo-electric thin-film layer shall be exchanged in the fabrication process.

### The Fourth Embodiment

The thin-film temperature-difference cell based on insulating substrate in the first embodiment may have the structure as follows:

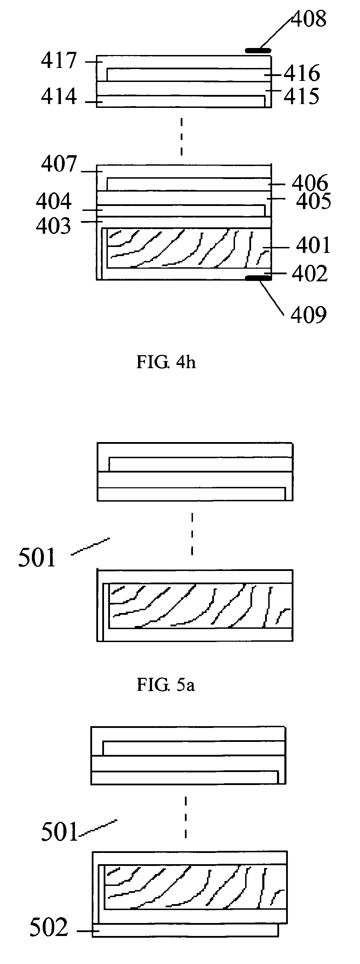

FIG. 4h is the cross-section view of the thin-film temperature-difference cell of this invention, which comprises an insulating substrate 401, a P-type thermo-electric thin-film layer 402, a N-type thermo-electric thin-film layer 403, an insulating thin-film layer 404, a P-type thermo-electric thin-film layer 405, an insulating thin-film layer 406, a N-type thermo-electric thin-film layer 407, an extractive electrode 408 and an extractive electrode 409.
FIG. 4a shows the P-type thermo-electric thin-film layer 402 deposited on one side of the insulating substrate 401;
FIG. 4b shows the N-type thermo-electric thin-film layer 403 deposited on the other side of the insulating substrate 401;
FIG. 4c shows the insulating thin-film layer 404 deposited on the N-type thermo-electric thin-film layer 403;

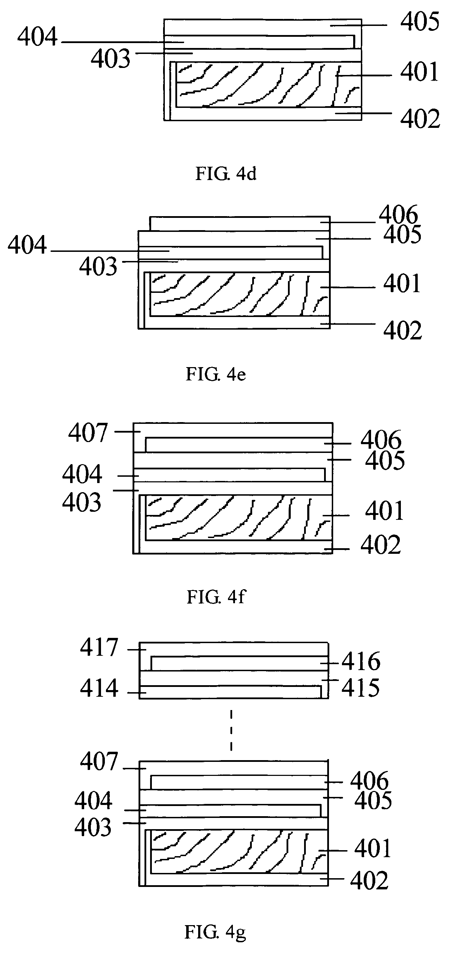

FIG. 4d shows the P-type thermo-electric thin-film layer 405 deposited on the insulating thin-film layer 404;
FIG. 4e shows the insulating thin-film layer 406 deposited on the P-type thermo-electric thin-film layer 405;
FIG. 4f shows N-type thermo-electric thin-film layer 407 deposited on the insulating thin-film layer 406;
FIG. 4g shows an insulating thin-film layer 414, a P-type thermo-electric thin-film layer 415, an insulating thin-film layer 416 and a N-type thermo-electric thin-film layer 417 formed by repeating depositing steps 414-415, thus a PN junction may connect with the deposited PN junctions. Multiple connections of three-layer PN junctions in series are available; an insulating thin-film is applied between every PN junction in series. The P-type thermo-electric thin-film layer and N-type thermo-electric thin-film layer of the three films are connected together at one end of the insulating thin-film layer, to form a PN junction. An insulating thin-film layer is applied between every two adjacent PN junctions, and the PN junctions separated by the insulating thin-film layer are connected together at one end of the insulating thin-film layer, to form connections of PN junctions in series. An electrode 408 and an electrode 409 are extracted from the N-type thermo-electric thin-film layer of last three-layer PN junction on the two sides of the insulating substrate, respectively.

### The Fifth Embodiment

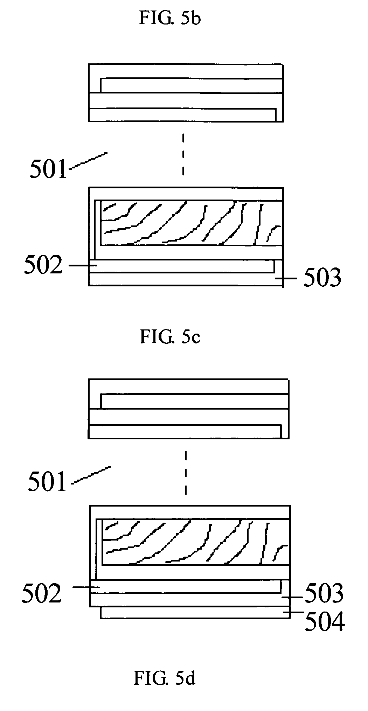

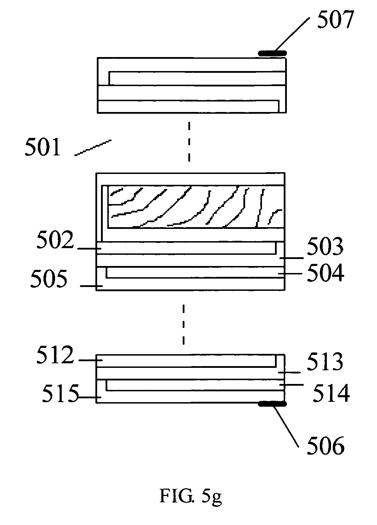

Based on the structure as shown in FIG. 4g, also depositing multiple connections in series of three-layer PN junctions on the other side of the P-type thermo-electric substrate, an insulating thin-film layer is provided between every three-layer PN junction, as shown in FIG. 5g. The thin-film temperature-difference cell in this embodiment comprises a structure basis 501 of the thin-film temperature-difference cell structure as shown in FIG. 4g, an insulating thin-film layer 502, a N-type thermo-electric thin-film layer 503, an insulating thin-film layer 504, a P-type thermo-electric thin-film layer 505 , an extractive electrode 506 and an extractive electrode 507.

FIG. 5a shows the structure basis 501 of the thin-film temperature-difference cell structure as shown in FIG. 4g;
FIG. 5b shows an insulating thin-film layer 502 deposited on the one side of the structure basis 501 of the thin-film temperature-difference cell structure as shown in FIG. 4 with P-type thermo-electric thin-film layer deposited on the other side thereof ;
FIG. 5d shows the insulating thin-film layer 504 deposited on the N-type thermo-electric thin-film layer 503;

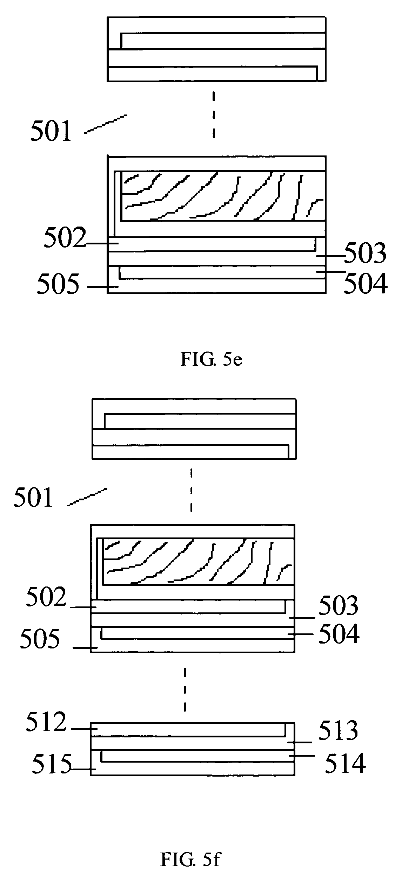

FIG. 5e shows the P-type thermo-electric thin-film layer 505 deposited on the insulating thin-film layer 504;
FIG. 5f shows an insulating thin-film layer 512, a P-type thermo-electric thin-film layer 513, an insulating thin-film layer 514 and a N-type thermo-electric thin-film layer 515 formed by repeating depositing steps 502-505, thus a PN junction may connect with the deposited PN junctions in series. Multiple connections of three-layer PN junctions in series are available; an insulating thin-film is applied between every PN junction. The P-type thermo-electric thin-film layer and N-type thermo-electric thin-film layer of the three films are connected together at one end of the insulating thin-film layer, to form a PN junction. An insulating thin-film layer is applied between every two adjacent PN junctions, and the PN junctions separated by the insulating thin-film layer are connected together at one end of the insulating thin-film layer, to form connections of PN junctions in series.

An electrode 506 and an electrode 507 are extracted from the N-type thermo-electric thin-film layer of last three-layer PN junction on the two sides of the insulating substrate, respectively. Thus, the main structure of the thin-film temperature-difference cell with the P-type thermo-electric material substrate deposited on both sides as shown in Fig. 5g is formed.

During the above-said fabrication process in the fifth embodiment, the depositing of N-type thermo-electric thin-film layer can be carried out before or after the depositing of P-type thermo-electric thin-film layer.

In all the embodiments described above, the substrate can be a regular rectangle or a regular square or in any irregular shapes. The common thickness range of the substrate is from 0.1mm to 100mm. The substrate with other thickness may also be suitable. The substrate can be an insulating substrate, a P-type thermo-electric thin-film or a N-type thermo-electric thin-film substrate, or any other material substrate. The P-type or N-type thermo-electric thin-film materials of each PN junction in the thin-film temperature-difference cell can be the same or different respectively, that is, in the entire thin-film temperature-difference cell, some PN junctions can be made of two different metal thin-film layer and insulating layer, and some can be made of a pair of P-type and N-type thermo-electric thin-film layers and insulating layer. During the deposition of insulating layers, one end of them is deliberately sheltered. Wherein, the ion beam sputtering deposition and magnetron sputtering in the first embodiment can also be applied in the second, third, fourth and fifth embodiment, and some other methods such as vacuum evaporation, Molecule Beam Epitaxy (MBE), Laser Deposition, electrochemical atomic layer epitaxy (ECALE), metal-organic chemical vapor deposition (MOCVD), and successive ionic layer adsorption and reaction (SILAR) can be applied. Then the thin-film temperature-difference cell is made by scribing, racking, packaging and related subsequent procedures.

Thermo-electric phenomenon is reversible, and the semiconductor thermo-electric generation and refrigeration can be reversible. For a single PN junction, if the temperature difference is used for electricity generation, then the electricity can be used for refrigeration in the other end. Thus, the main thin-film temperature-difference cell structure can be the main structure of the thin-film thermo-electric cooler.

## Claims

1. A thin-film thermo-electric generator, **characterized in that** comprises:
a substrate, a plurality of P-type thermo-electric thin-film layer, a plurality of insulating thin-film layer, a plurality of N-type thermo-electric thin-film layer and two electrodes; wherein the P-type thermo-electric thin-film layer and the N-type thermo-electric thin-film layer are deposited on two opposed sides of said substrate, and alternating with each other;
a three-layer film formed by a group of said P-type thermo-electric thin-film layer, said insulating thin-film layer and said N-type thermo-electric thin-film layer, wherein said P-type thermo-electric thin-film layer and said N-type thermo-electric thin-film layer of said three-layer film are connected together at one end of said insulating thin-film layer to form a PN junction;
an insulating layer deposited between two adjacent said PN junctions for separating, wherein said two adjacent PN junctions separated by said insulating layer are connected together at one end of the insulating layer, in order to form PN junctions in series;
wherein the two electrodes are respectively extracted from the outermost thin-film layer on two sides of said substrate.

2. A thin-film thermo-electric generator according to claim 1, **characterized in that**, the thickness range of said substrate is 0.1 mm -100mm, the thickness range of said P-type thermo-electric thin-film layer is 1 nm-10µm, and the thickness range of said N-type thermo-electric thin-film layer is 1 nm-10µm.

3. A thin-film thermo-electric generator according to claim 1, **characterized in that**, the shape of said substrate is regular rectangle or square.

4. A thin-film thermo-electric generator according to claim 1, **characterized in that**, the shape of the exposed sides of the substrate are plane or curved surface.

5. A thin-film thermo-electric generator according to claim 1, **characterized in that**, the substrate is an insulating substrate, a P-type thermo-electric substrate or an N-type thermoelectric substrate.

6. A method for fabricating a thin-film thermo-electric generator, **characterized in that** depositing multilayer films on the two sides of the substrate, and further comprises steps as follows:
selecting a substrate and sheltering one side of said substrate;
depositing a P-type thermo-electric thin-film layer on one side of the substrate;
sheltering said substrate and sheltering one end and all sides of the deposited thin-film layer, and depositing an insulating thin-film layer on said P-type thermo-electric thin-film layer;
sheltering said substrate and the sides of the deposited thin-film layer, depositing a N-type thermo-electric thin-film layer on the deposited insulating thin-film layer to form a three-layer film, wherein the P-type thermo-electric thin-film layer and N-type thermo-electric thin-film layer of said three-layer film are connected together at said sheltered end of the substrate to form a PN junction;
repeating the steps of sheltering said substrate and the sides of the deposited thin-film layer, depositing a N-type thermo-electric thin-film layer on the deposited insulating thin-film layer to form a three-layer film and forming a PN junction by connecting the P-type thermo-electric thin-film layer and N-type thermo-electric thin-film layer of said three-layer film together at said sheltered end of the substrate to form multiple PN junctions;
depositing an insulating thin-film layer between every two adjacent PN junctions while sheltering said substrate and sheltering the other end and all sides of the deposited thin-film layers during the depositing process, wherein said two adjacent three-layer PN junctions are connected together at the other sheltered end of said deposited thin-film layers to form PN junctions in series;
extracting one electrode from the outermost thin-film layer of the last three-layer PN junction;
repeating the steps described above to form multiple three-layer PN junctions in series on the other side of said substrate, extracting another electrode from the outermost thin-film layer of the last three-layer PN junction on the other side of said substrate, to form the main structure of a thin-film thermo-electric generator.

## Patentansprüche

1. Thermoelektrischer Dünnfilm-Generator, **dadurch gekennzeichnet, dass** er aufweist:
ein Substrat, eine Vielzahl von thermoelektrischen Dünnfilmschichten vom P-Typ, eine Vielzahl von isolierenden Dünnfilmschichten, eine Vielzahl von thermoelektrischen Dünnfilmschichten vom N-Typ und zwei Elektroden; wobei die thermoelektrische Dünnfilmschicht vom P-Typ und die thermoelektrische Dünnfilmschicht vom N-Typ auf zwei gegenüberliegenden Seiten des Substrats und einander abwechselnd abgeschieden werden;
einen Dreischicht-Film, der durch eine Gruppe der thermoelektrischen Dünnfilmschicht vom P-Typ, der isolierenden Dünnfilmschicht und der thermoelektrischen Dünnfilmschicht vom N-Typ gebildet wird, wobei die thermoelektrische Dünnfilmschicht vom P-Typ und die thermoelektrische Dünnfilmschicht vom N-Typ des Dreischicht-Films an einem Ende der isolierenden Dünnfilmschicht miteinander verbunden sind, um einen PN-Übergang zu bilden;
eine Isolierschicht, die zwischen zwei benachbarten PN-Übergängen zur Trennung abgeschieden ist, wobei die zwei benachbarten PN-Übergänge, die durch die Isolierschicht getrennt sind, an einem Ende der Isolierschicht miteinander verbunden sind, um PN-Übergänge in Reihe zu bilden;
wobei die beiden Elektroden jeweils aus der äußersten Dünnfilmschicht auf zwei Seiten des Substrats extrahiert werden.

2. Thermoelektrischer Dünnfilm-Generator nach Anspruch 1, **dadurch gekennzeichnet, dass** der Stärkebereich des Substrats zwischen 0,1 mm und 100 mm liegt, der Stärkebereich der thermoelektrischen Dünnfilmschicht vom P-Typ zwischen 1 nm und 10 µm liegt, und der Stärkebereich der thermoelektrischen Dünnfilmschicht vom N-Typ zwischen 1 nm und 10 µm liegt.

3. Thermoelektrischer Dünnfilm-Generator nach Anspruch 1, **dadurch gekennzeichnet, dass** die Form des Substrats ein regelmäßiges Rechteck oder Quadrat ist.

4. Thermoelektrischer Dünnfilm-Generator nach Anspruch 1, **dadurch gekennzeichnet, dass** die Form der freiliegenden Seiten des Substrats eine ebene oder gebogene Oberfläche ist.

5. Thermoelektrischer Dünnfilm-Generator nach Anspruch 1, **dadurch gekennzeichnet, dass** das Substrat ein Isoliersubstrat, ein thermoelektrisches Substrat vom P-Typ oder ein thermoelektrisches Substrat vom N-Typ ist.

6. Verfahren zum Herstellen eines thermoelektrischen Dünnfilm-Generators, **gekennzeichnet durch** Abscheiden von Mehrschichtfilmen auf den beiden Seiten des Substrats, und des Weiteren die folgenden Schritte umfassend:
Auswählen eines Substrats und Abschirmen einer Seite des Substrats;
Abscheiden einer thermoelektrischen Dünnfilmschicht vom P-Typ auf einer Seite des Substrats;
Abschirmen des Substrats und Abschirmen eines Endes und aller Seiten der abgeschiedenen Dünnfilmschicht, und Abscheiden einer isolierenden Dünnfilmschicht auf der thermoelektrischen Dünnfilmschicht vom P-Typ;
Abschirmen des Substrats und der Seiten der abgeschiedenen Dünnfilmschicht, Abscheiden einer thermoelektrischen Dünnfilmschicht vom N-Typ auf der abgeschiedenen isolierenden Dünnfilmschicht, um einen Dreischichtfilm zu bilden, wobei die thermoelektrische Dünnfilmschicht vom P-Typ und die thermoelektrische Dünnfilmschicht vom N-Typ des Dreischichtfilms an dem geschützten Ende des Substrats miteinander verbunden werden, um einen PN-Übergang zu bilden;
Wiederholen der Schritte des Abschirmens des Substrats und der Seiten der abgeschiedenen Dünnfilmschicht, des Abscheidens einer thermoelektrischen Dünnfilmschicht vom N-Typ auf der abgeschiedenen isolierenden Dünnfilmschicht, um einen Dreischichtfilm zu bilden, und des Bildens eines PN-Übergangs **durch** Verbinden der thermoelektrischen Dünnfilmschicht vom P-Typ und der thermoelektrischen Dünnfilmschicht vom N-Typ des Dreischichtfilms an dem geschützten Ende des Substrats, um mehrere PN-Übergänge zu bilden;
Abscheiden einer isolierenden Dünnfilmschicht zwischen jeweils zwei benachbarten PN-Übergängen während des Abschirmens des Substrats und des Abschirmens des anderen Endes und aller Seiten der abgeschiedenen Dünnfilmschichten während des Abscheidevorgangs, wobei die beiden benachbarten Dreischicht-PN-Übergänge an dem anderen geschützten Ende der abgeschiedenen Dünnfilmschichten verbunden werden, um PN-Übergänge in Reihe zu bilden;
Extrahieren einer Elektrode aus der äußersten Dünnfilmschicht des letzten Dreischicht-PN-Übergangs;
Wiederholen der oben beschriebenen Schritte, um mehrere Dreischicht-PN-Übergänge in Reihe auf der anderen Seite des Substrats zu bilden, Extrahieren einer anderen Elektrode aus der äußersten Dünnfilmschicht des letzten Dreischicht-PN-Übergangs auf der anderen Seite des Substrats, um die Hauptstruktur eines thermoelektrischen Dünnfilmgenerators zu bilden.

## Revendications

1. Générateur thermoélectrique à films minces, **caractérisé en ce qu'**il comprend :
un substrat, une pluralité de couche de film mince thermoélectrique de type P, une pluralité de couche de film mince isolante, une pluralité de couche de film mince thermoélectrique de type N et deux électrodes ; dans lequel la couche de film mince thermoélectrique de type P et la couche de film mince thermoélectrique de type N sont déposées sur deux côtés opposés dudit substrat, et en alternance les unes avec les autres ;
un film à trois couches formé par un groupe de ladite couche de film mince thermoélectrique de type P, ladite couche de film mince isolante et ladite couche de film mince thermoélectrique de type N, dans lequel ladite couche de film mince thermoélectrique de type P et ladite couche de film mince thermoélectrique de type N dudit film à trois couches sont reliées entre elles à une extrémité de ladite couche de film mince isolante pour former une jonction PN ;
une couche isolante déposée entre deux desdites jonctions PN adjacentes pour une séparation, dans laquelle lesdites deux jonctions PN adjacentes séparées par ladite couche isolante sont reliées entre elles à une extrémité de la couche isolante, afin de former des jonctions PN en série ;
dans lequel les deux électrodes sont extraites respectivement de la couche de film mince la plus extérieure sur deux côtés dudit substrat.

2. Générateur thermoélectrique à films minces selon la revendication 1, **caractérisé en ce que**, la gamme d'épaisseur dudit substrat est de 0,1 mm à 100 mm, la gamme d'épaisseur de ladite couche de film mince thermoélectrique de type P est de 1 nm à 10 µm, et la gamme d'épaisseur de ladite couche de film mince thermoélectrique de type N est de 1 nm à 10 µm.

3. Générateur thermoélectrique à films minces selon la revendication 1, **caractérisé en ce que**, la forme dudit substrat est un rectangle ou un carré régulier.

4. Générateur thermoélectrique à films minces selon la revendication 1, **caractérisé en ce que** la forme des côtés exposés du substrat est une surface plane ou incurvée.

5. Générateur thermoélectrique à films minces selon la revendication 1, **caractérisé en ce que** le substrat est un substrat isolant, un substrat thermoélectrique de type P ou un substrat thermoélectrique de type N.

6. Procédé de fabrication d'un générateur thermoélectrique à films minces, **caractérisé par** le dépôt de films multicouches sur les deux côtés du substrat, et en ce qu'il comprend en outre les étapes comme suit :
sélectionner un substrat et protéger un côté dudit substrat ;
déposer une couche de film mince thermoélectrique de type P sur un côté du substrat ;
protéger ledit substrat et protéger une extrémité et tous les côtés de la couche de film mince déposée, et déposer une couche de film mince isolante sur ladite couche de film mince thermoélectrique de type P ;
protéger ledit substrat et les côtés de la couche de film mince déposée, déposer une couche de film mince thermoélectrique de type N sur la couche de film mince isolante déposée pour former un film à trois couches, dans lequel la couche de film mince thermoélectrique de type P et la couche de film mince thermoélectrique de type N dudit film à trois couches sont reliées entre elles au niveau de ladite extrémité protégée du substrat pour former une jonction PN ;
répéter les étapes de protection dudit substrat et des côtés de la couche de film mince déposée, déposer une couche de film mince thermoélectrique de type N sur la couche de film mince isolante déposée pour former un film à trois couches et former une jonction PN en reliant entre elles la couche de film mince thermoélectrique de type P et la couche de film mince thermoélectrique de type N dudit film à trois couches au niveau de ladite extrémité protégée du substrat pour former de multiples jonctions PN ;
déposer une couche de film mince isolante entre chacune de deux jonctions PN adjacentes tout en protégeant ledit substrat et en protégeant l'autre extrémité et tous les côtés des couches de film mince déposées au cours du processus de dépôt, dans lequel lesdites deux jonctions PN à trois couches adjacentes sont reliées entre elles à l'autre extrémité protégée desdites couches de film mince déposées pour former des jonctions PN en série ;
extraire une électrode de la couche de film mince la plus extérieure de la dernière jonction PN à trois couches ;
répéter les étapes décrites ci-dessus pour former de multiples jonctions PN à trois couches en série sur l'autre côté dudit substrat, extraire une autre électrode de la couche de film mince la plus extérieure de la dernière jonction PN à trois couches sur l'autre côté dudit substrat, pour former la structure principale d'un générateur thermoélectrique à films minces.
